# EUROPEAN PATENT APPLICATION

(11) **EP 2 233 875 A1**
(43) Date of publication of application: **29.09.2010**
(21) Application number: 08862674.2
(22) Date of filing: 16.12.2008
(51) Int. Cl.: F28F 3/06, F25D 1/00, F28F 3/08, F28F 21/06

(54) **HEAT EXCHANGE DEVICE AND DEVICE FOR RECEIVING HEAT GENERATION BODY**

(30) Priority: 17.12.2007 JP 2007324357; 18.01.2008 JP 2008008876; 12.11.2008 JP 2008289549
(71) Applicant: Panasonic Corporation, Kadoma-shi Osaka 571-8501 (JP)
(72) Inventor: MURAYAMA, Takuya, Chuo-ku, Osaka-shi, Osaka 540-6207 (JP); SUGIYAMA, Makoto, Chuo-ku, Osaka-shi, Osaka 540-6207 (JP); KATSUMI, Yoshimasa, Chuo-ku, Osaka-shi, Osaka 540-6207 (JP); MATSUMOTO, Mutsuhiko, Chuo-ku, Osaka-shi, Osaka 540-6207 (JP); TSUJI, Keisuke, Chuo-ku, Osaka-shi, Osaka 540-6207 (JP); FUNADA, Naoyuki, Chuo-ku, Osaka-shi, Osaka 540-6207 (JP); SHIBATA, Hiroshi, Chuo-ku, Osaka-shi, Osaka 540-6207 (JP)
(74) Representative: Muschke, Markus Artur Heinz
(86) International application number: PCT/JP2008/003781
(87) International publication number: WO 2009/078168

(57) **Abstract**

In the heat exchanger of a heat exchange device of the present invention, first protrusions (26) are provided on a part of first rectification walls (22) of first plate member (15) so as to protrude into first recessed portions (25) which are formed on second plate member (16) close to first plate member (15) when second rectification walls are formed on second plate member (16). Second protrusions (27) are provided on a part of second rectification walls (23) of second plate member (16) so as to protrude into second recessed portions (25a) which are formed on third plate member (17) close to second plate member (16) when third rectification walls (24) are formed on third plate member (17).

## Description

### TECHNICAL FIELD

The present invention relates to a heat exchange device and a device for a receiving heat generation body using the same.

### BACKGROUND ART

In recent years, with the development of telecommunication networks, the number of cellular phones has increased dramatically compared to the number of fixed-line phones, and a number of base stations of cellular phones have been installed accordingly. From a certain perspective, the base stations of cellular phones may be regarded as extremely large heat generation bodies or sources from the viewpoint of the fact that they consume power, because an electric current of several tens of amperes or higher, for example, flows therethrough. In a cellular phone base station which serves as such a heat generation body, since many electronic devices are installed in the base station, there is a problem in that the operating temperature of the electronic devices rises due to heat generated from the base station itself, thus disturbing stable operation.

To solve such a problem, it is very important to cool down the base station serving as a heat generation body in order to ensure the long-term stable operation of the many electronic devices in the base station. In the related art, such a cellular phone base station has a configuration as described below so as to achieve cooling of the base station itself.

That is to say, a device for receiving a heat generation body as a cellular phone base station is configured to include a cabinet that receives electronic devices such as a transmitter or a receiver serving as a heat generation body and a heat exchange device mounted on an opening of the cabinet. The heat exchange device has a structure as described below, for example.

That is to say, the heat exchange device is configured to include a body case having a first intake port and a first discharge port for outside air and a second intake port and a second discharge port for air inside the cabinet, a blast fan, and a heat exchanger. Here, the blast fan is configured to include a first blast fan for outside air and a second blast fan for air inside the cabinet which are provided in the body case. Moreover, the heat exchanger performs heat exchange between the outside air and the air inside the cabinet in the body case.

The heat exchanger has a structure, for example, in which a second plate member is stacked on the surface of a first plate member with a predetermined gap therebetween, and a third plate member is stacked on the surface of the second plate member with a predetermined gap therebetween. A plurality of first rectification walls that partitions the surface of the first plate member into a lane shape is provided on the surface of the first plate member opposing the second plate member. Moreover, a plurality of second rectification walls that partitions the surface of the second plate member into a lane shape is provided on the surface of the second plate member opposing the third plate member.

As prior art citation information related to the invention of this application, Patent Citation 1 is known, for example.

In the heat exchanger of the conventional heat exchange device described above, rectification walls are provided on the surface of the first plate member and the second plate member, for example. In this way, the outside air and the air inside the cabinet can flow smoothly and uniformly over the large surfaces of the first plate member and the second plate member, thus increasing the heat exchange efficiency of the heat exchanger.

When producing such a heat exchanger, the first plate member and the second plate member can be formed relatively easily by integral molding. For example, the use of synthetic resin or the like enables forming the rectification walls at once. Therefore, it can be said that the heat exchanger can be produced with extremely high productivity.

However, in many cases, since the cellular phone base station is installed outdoors, if the outside air temperature is high, the internal temperature of the cabinet will rise too high. When the internal temperature rises to such a high temperature, in the heat exchanger made from synthetic resin or the like, the first plate member and the second plate member will thermally expand because they are made from synthetic resin. As a result, the expanded walls of these plate members may sag between the rectification walls. Thus, there is a problem in that the flow of air is not rectified smoothly, the air-flow resistance increases, and the heat exchange efficiency decreases.
Patent Citation 1: JP-A-10-170176

### DISCLOSURE OF THE INVENTION

The present invention solves the above-mentioned problems and provides a heat exchange device capable of stably operating with high heat exchange efficiency and high mass-productivity.

A heat exchange device of the present invention includes a body case having a first intake port and a first discharge port for a first environment, and a second intake port and a second discharge port for a second environment; a first blast fan for the first environment and a second blast fan for the second environment which are provided in the body case; and a heat exchanger that performs heat exchange between air of the first environment and air of the second environment in the body case. The heat exchanger has a structure in which a second synthetic resin-made plate member is stacked on the surface of a first synthetic resin-made plate member with a predetermined gap therebetween, and a third synthetic resin-made plate member is stacked on the surface of the second plate member with a predetermined gap therebetween. A plurality of first rectification walls that partitions the surface of the first plate member into a lane shape is formed on the surface of the first plate member to confront the second plate member, , a plurality of second rectification walls that partitions the surface of the second plate member into a lane shape is formed on the surface of the second plate member to confront the third plate member, , and a plurality of third rectification walls that partitions the surface of the third plate member into a lane shape is formed on the surface of the third plate member opposite to the second plate member. First protrusions are provided on parts of the first rectification walls of the first plate member so as to protrude into first recessed portions which are formed on the second rectification walls, confronting the first plate member, of the second plate member, and second protrusions are provided on parts of the second rectification walls of the second plate member so as to protrude into second recessed portions which are formed on the third rectification walls, confronting the second plate member, of the third plate member.

With such a configuration, it is possible to decrease air-flow resistance and to thus achieve smooth rectification of the flow of air. Therefore, it is possible to realize a heat exchange device capable of operating stably with high heat exchange efficiency and high mass-productivity.

That is to say, in the heat exchange device of the present invention, the plurality of first rectification walls partitioning the surface of the first plate member into a lane shape and the plurality of second rectification walls partitioning the surface of the second plate member into a lane shape are provided, respectively. In this way, it is possible to form a uniform flow of air over approximately the entire surface of the first plate member and the second plate member by the first rectification walls and the second rectification walls and to thus perform smooth rectification of the flow of air.

Furthermore, in the portion where the uniform flow of air is formed, the first protrusions are provided in a part of the first rectification walls of the first plate member so as to protrude into the first recessed portions on the side of the first plate member, and the second protrusions are provided in a part of the second rectification walls of the second plate member so as to protrude into the second recessed portions on the side of the second plate member. In this way, even when a temperature rise such as increased air temperature occurs, the first plate member, the second plate member, and the third plate member are prevented from being greatly deformed in the direction towards their adjacent plate member, whereby the air-flow path on the surfaces of the plate members is prevented from being narrowed or blocked. As a result, it is possible to achieve smooth rectification of the flow of air, decrease the air-flow resistance, and improve the heat exchange efficiency. Therefore, it is possible to realize a heat exchange device capable of operating stably with high heat exchange efficiency.

Moreover, a heat exchange device of the present invention includes a body case having a first intake port and a first discharge port for a first environment, and a second intake port and a second discharge port for a second environment; a first blast fan for the first environment and a second blast fan for the second environment which are provided in the body case; and a heat exchanger that performs heat exchange between air of the first environment and air of the second environment in the body case. The heat exchanger has a structure in which a second synthetic resin-made plate member is stacked on the surface of a first synthetic resin-made plate member with a predetermined gap therebetween, and a third synthetic resin-made plate member is stacked on the surface of the second plate member with a predetermined gap therebetween. A plurality of first rectification walls that partitions the surface of the first plate member into a lane shape is formed on the surface of the first plate member to confront the second plate member, , and a plurality of second rectification walls that partitions the surface of the second plate member into a lane shape is formed on the surface of the second plate member to confront the third plate member,. First protrusions are provided between the first plurality of rectification walls on the surface, confronting the second plate member, of the first plate member so as to protrude towards the second plate member, and second protrusions are provided between the second plurality of rectification walls on the surface, confronting the third plate member, of the second plate member so as to protrude towards the third plate member.

With such a configuration, it is possible to decrease air-flow resistance and to thus achieve smooth rectification of the flow of air. Therefore, it is possible to realize a heat exchange device capable of operating stably with high heat exchange efficiency and high mass-productivity.

That is to say, in the heat exchange device of the present invention, the plurality of first rectification walls that partitions the surface of the first plate member into a lane shape and the plurality of second rectification walls that partitions the surface of the second plate member into a lane shape are provided. Moreover, the first protrusions are provided between the first plural rectification walls so as to protrude towards the second plate member, and the second protrusions are provided between the second plurality of rectification walls so as to protrude towards the third plate member.

In this way, it is possible to form a uniform flow of air over approximately the entire surface of the first plate member and the second plate member by the first rectification walls and the second rectification walls. Moreover, since the first protrusions and the second protrusions are provided in the portion where the uniform flow of air is formed, even when a situation such as increased air temperature occurs, the air-flow path is prevented from being narrowed or blocked. As a result, it is possible to achieve smooth rectification of the flow of air, decrease the air-flow resistance, and improve the heat exchange efficiency. Therefore, it is possible to realize a heat exchange device capable of operating stably with high heat exchange efficiency.

Moreover, a device for accommodating a heat generation body of the present invention includes a cabinet for accommodating a heat generation body and the above-mentioned heat exchange device mounted to an opening of the cabinet.

With such a configuration, it is possible to realize a device for accommodating a heat generation body, accommodating a heat exchange device which is capable of operating stably with high heat exchange efficiency.

### BRIEF DESCRIPTION OF THE DRAWINGS

Fig. 1 is a perspective view showing an installation example of a heat exchange device according to Embodiment 1 of the present invention.
Fig. 2 is a cross-sectional view of the heat exchange device according to Embodiment 1 of the present invention.
Fig. 3 is an exploded perspective view of the heat exchange device according to Embodiment 1 of the present invention.
Fig. 4 is a perspective view of the heat exchange device according to Embodiment 1 of the present invention.
Fig. 5A is an exploded perspective view of the heat exchanger of the heat exchange device according to Embodiment 1 of the present invention.
Fig. 5B is a perspective view of the heat exchanger of the heat exchange device according to Embodiment 1 of the present invention.
Fig. 6 is a perspective view of the heat exchanger of the heat exchange device according to Embodiment 1 of the present invention.
Fig. 7 is a cross-sectional view of the heat exchanger of the heat exchange device, taken along the line A-A of Fig. 5B.
Fig. 8 is a top plan view of the heat exchanger of another heat exchange device according to Embodiment 1 of the present invention.
Fig. 9 is an exploded perspective view of the heat exchanger of another heat exchange device according to Embodiment 1 of the present invention.
Fig. 10 is a partial enlarged perspective view of the heat exchanger of another heat exchange device according to Embodiment 1 of the present invention.
Fig. 11 is a partial enlarged perspective view of the heat exchanger of a still another heat exchange device according to Embodiment 1 of the present invention.
Fig. 12 is an exploded perspective view of the heat exchanger of a heat exchange device according to Embodiment 2 of the present invention.
Fig. 13 is a perspective view of the heat exchanger of the heat exchange device according to Embodiment 2 of the present invention.
Fig. 14A is a perspective view of a main part of the heat exchanger of the heat exchange device according to Embodiment 2 of the present invention.
Fig. 14B is an enlarged perspective view of the part surrounded by the broken line in Fig. 14A.
Fig. 15A is a perspective view of a main part of the heat exchanger of the heat exchange device according to Embodiment 2 of the present invention.
Fig. 15B is an enlarged perspective view of the part surrounded by the broken line in Fig. 15A.

### DESCRIPTION OF REFERENCE NUMERALS AND SIGNS

1: BUILDING
2: ROOFTOP
3: BASE STATION
4: DEVICE FOR ACCOMMODATING HEAT GENERATION BODY (CABINET)
5: TRANSCEIVER
6: HEAT EXCHANGE DEVICE
7: FIRST INTAKE PORT
8: FIRST DISCHARGE PORT
9: SECOND INTAKE PORT
10: SECOND DISCHARGE PORT
11: BODY CASE
12: FIRST BLAST FAN
13: SECOND BLAST FAN
14, 114: HEAT EXCHANGER
15, 115: FIRST PLATE MEMBER
15a, 16a, 115a, 116a: ONE END
15b, 16b, 115b, 116b: THE OTHER END
15c, 115c: FIRST LONG SIDE
16, 116: SECOND PLATE MEMBER
16c, 116c: SECOND LONG SIDE
17, 117: THIRD PLATE MEMBER
17a, 117a: FOURTH PLATE MEMBER
18, 20, 118, 120: INLET PORT
19, 21, 119, 121: OUTLET PORT
22, 122: FIRST RECTIFICATION WALL
23, 123: SECOND RECTIFICATION WALL
24: THIRD RECTIFICATION WALL
25: FIRST RECESSED PORTION
25a: SECOND RECESSED PORTION
25b: THIRD RECESSED PORTION
26, 124: FIRST PROTRUSION
27, 125: SECOND PROTRUSION
28, 126: FIRST CURVED PORTION
29, 127: SECOND CURVED PORTION
30: FIRST SEALING PROTRUSION
30a: SECOND SEALING PROTRUSION
128: CURVED FACE

### PREFERRED EMBODIMENTS FOR CARRYING OUT THE INVENTION

Hereinafter, exemplary embodiments of the present invention will be described with reference to the drawings. In the drawings below, the same elements are denoted by the same reference numerals, and description thereof may sometimes be omitted.

### Embodiment 1

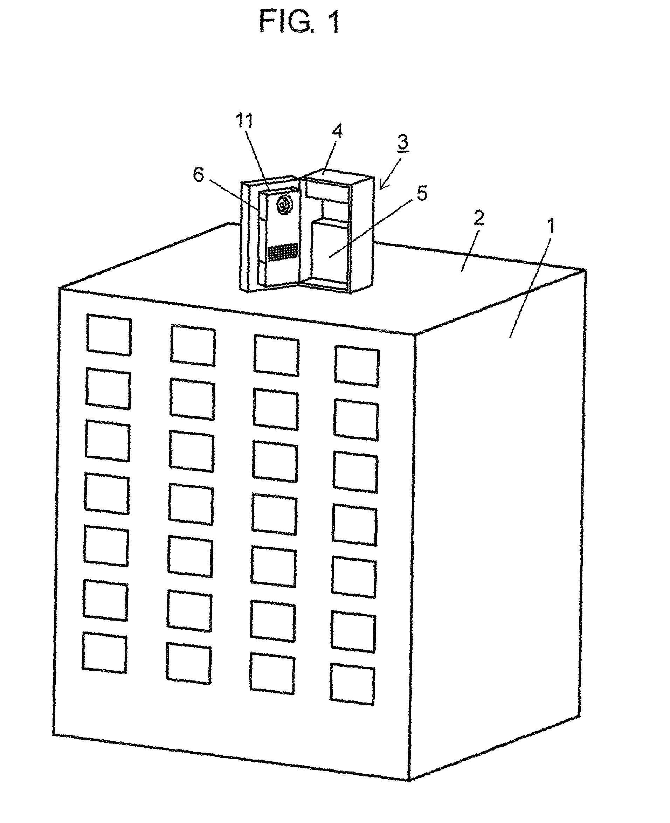

Fig. 1 is a perspective view showing an installation example of a heat exchange device according to Embodiment 1 of the present invention.

As shown in Fig. 1, base station 3 of cellular phones is installed on rooftop 2 of building 1. Base station 3 includes box-like cabinet 4 which is a device for accommodating a heat generation body, transceiver 5 provided in cabinet 4, and heat exchange device 6 which is provided to an opening of the front surface of cabinet 4 so as to be openable like a door. Transceiver 5 incorporates therein electronic equipment such as a transmitter or a receiver.

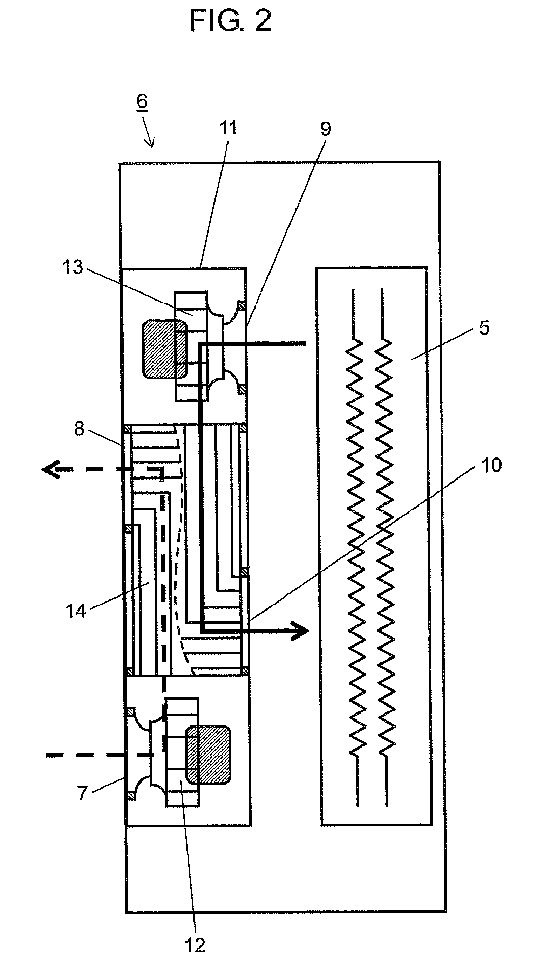

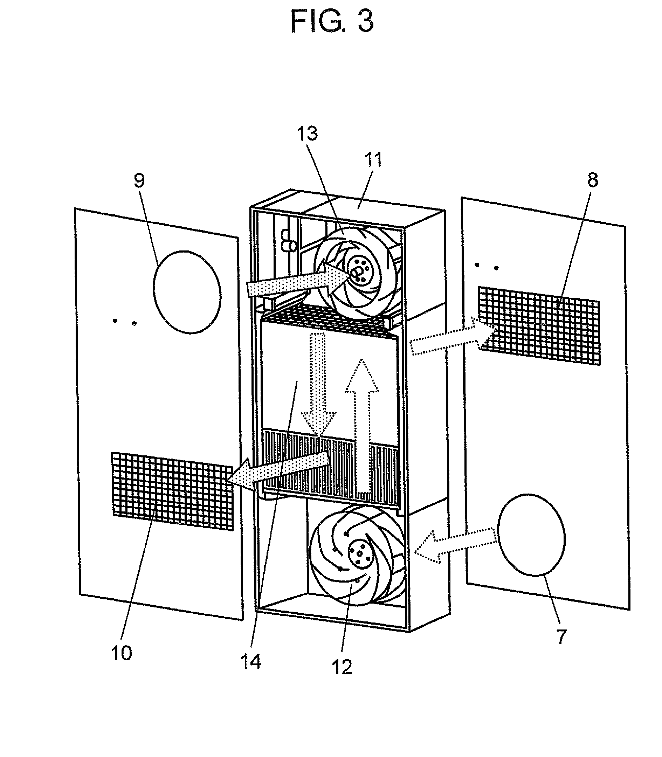

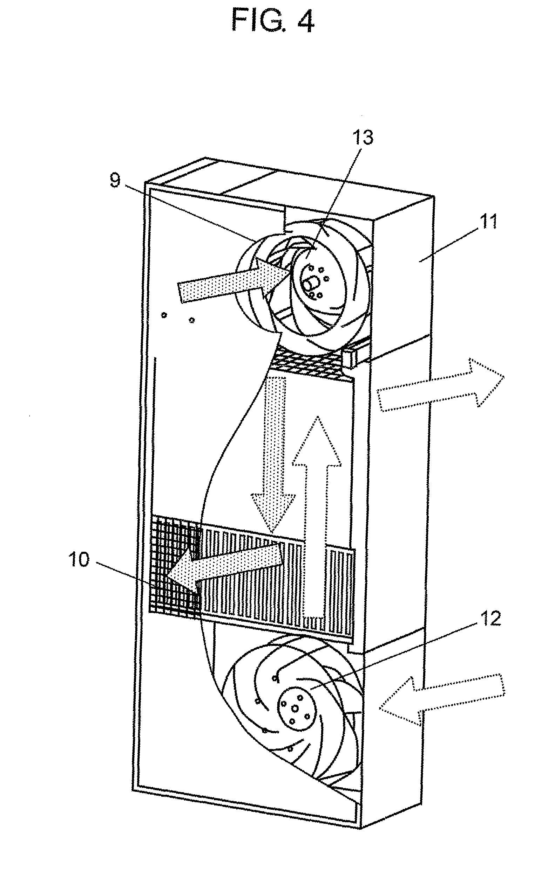

Fig. 2 is a cross-sectional view of the heat exchange device according to Embodiment 1 of the present invention. Fig. 3 is an exploded perspective view of the heat exchange device according to Embodiment 1 of the present invention. Fig. 4 is a perspective view of the heat exchange device according to Embodiment 1 of the present invention.

As shown in Figs. 2 to 4, heat exchange device 6 is provided with body case 11, first blast fan 12 for outside air (hereinafter referred to as "first environment") and second blast fan 13 for air inside cabinet 4 (hereinafter referred to as "second environment") which are provided in body case 11, and heat exchanger 14. Here, body case 11 has first intake port 7 and first discharge port 8 for the first environment and second intake port 9 and second discharge port 10 for the second environment. Heat exchanger 14 performs heat exchange in body case 11 between the outside air and the air inside cabinet 4.

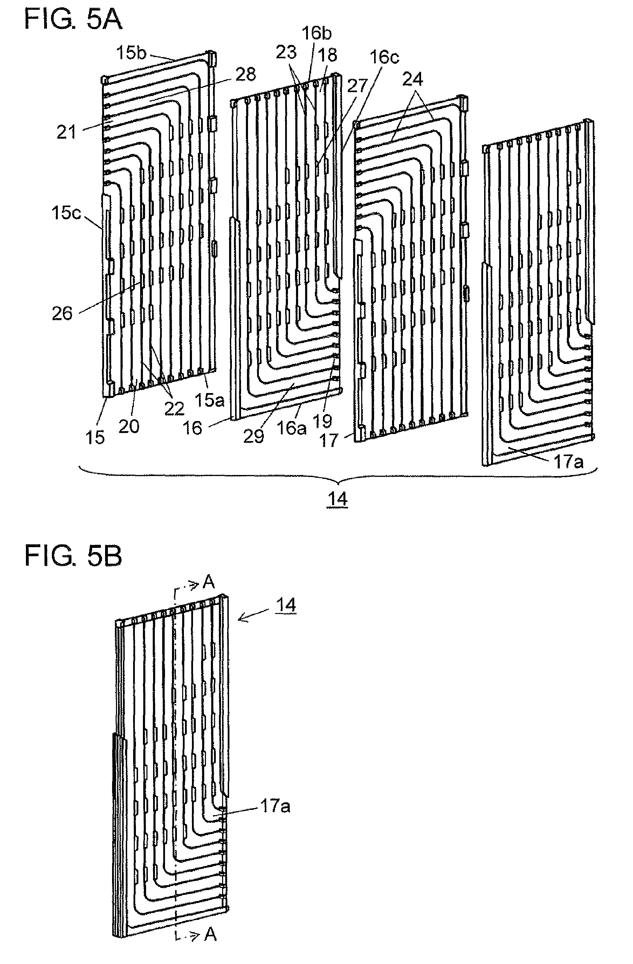

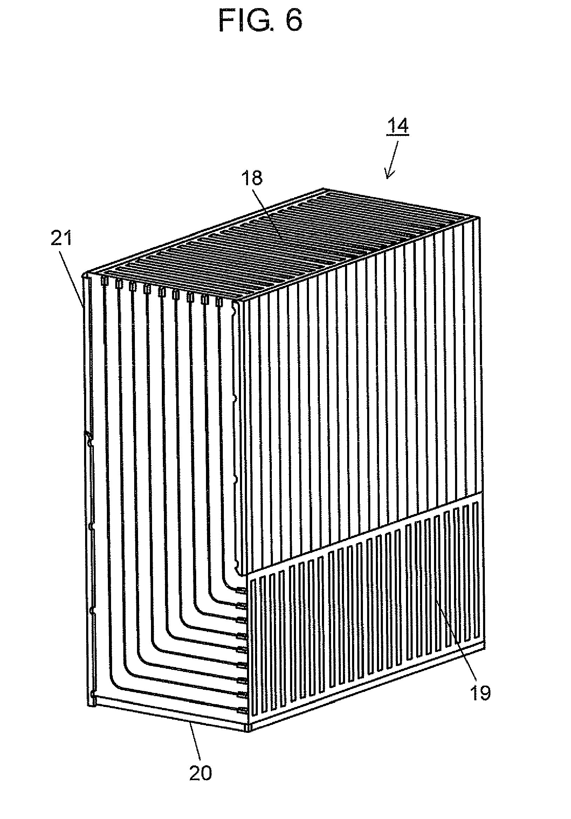

Fig. 5A is an exploded perspective view of the heat exchanger of the heat exchange device according to Embodiment 1 of the present invention. Fig. 5B is a perspective view of the heat exchanger of the heat exchange device according to Embodiment 1 of the present invention. Fig. 6 is a perspective view of the heat exchanger of the heat exchange device according to Embodiment 1 of the present invention.

As shown in Figs. 5A, 5B, and 6, heat exchanger 14 has a structure, for example, in which second synthetic resin-made plate member 16 is stacked on the surface of first synthetic resin-made plate member 15 with a predetermined gap therebetween, and third synthetic resin-made plate member 17 is stacked on the surface of second plate member 16 with a predetermined gap therebetween, as shown in Fig. 6. Here, plate members 15, 16, and 17 are made from synthetic resin due to its good moldability and high mass-productivity, and other similar materials having the same properties may be used. Moreover, plate members 15, 16, and 17 have a rectangular shape in this example. In Fig. 5A, although three plate members 15, 16, and 17 are stacked, a plurality of plate members may be stacked, for example, by stacking additional fourth plate member 17a and the like above third plate member 17. A perspective view of heat exchanger 14 obtained by stacking the plurality of plate members shown in Fig. 5A to be integrated therewith is shown in Fig. 5B.

The top surface (in Fig. 6) of heat exchanger 14 stacked thus serves as inlet 18 in which the air inside cabinet 4 is drawn via second intake port 9. The air drawn from inlet port 18 into heat exchanger 14 is discharged into cabinet 4 via outlet port 19 which is provided on the right side of the lower part in Fig. 6. The discharged air is used for cooling down transceiver 5 which is disposed opposite heat exchanger 14 shown in Fig. 1.

The outside air from the outside of cabinet 4 is drawn from inlet port 20, which is provided on the lower surface in Fig. 6, and is discharged as outside air to the outside of cabinet 4 via outlet port 21 which is provided on the left side of the upper part.

Although such a ventilation will be described in further detail later, heat exchanger 14 performs heat exchange between the outside air and the inside air of cabinet 4, thus cooling down transceiver 5 using the outside air.

That is to say, since electric current of several tens of amperes or more flows through transceiver 5, transceiver 5 generates heat by consuming this electric current and the temperature thereof will rise accordingly. When such a temperature rise resulting from the heat generated from transceiver 5 itself is left as it is, the characteristics of the electronic equipment or the like provided in transceiver 5 may become unstable. Therefore, as described above, Embodiment 1 has a structure in which heat exchanger 14 performs heat exchange between the outside air and the air flowing inside cabinet 4 to cool down the inside air, thus cooling down and suppressing heat generation of transceiver 5, and preventing the operation of transceiver 5 from becoming unstable.

Heat exchanger 14 described above is obtained by sequentially stacking second rectangular synthetic resin-made plate member 16 on the surface of first rectangular synthetic resin-made plate member 15 and third synthetic resin-made plate member 17 on the surface of second plate member 16 as shown in Fig. 5A.

More specifically, a plurality of first rectification walls 22 that partitions the surface of first plate member 15 into a lane shape is provided on the surface of first plate member 15 to confront the second plate member 16. Moreover, a plurality of second rectification walls 23 that partitions the surface of second plate member 16 into a lane shape is provided on the surface of second plate member 16 to confront the third plate member 17. Furthermore, third rectification walls 24 that protrude towards a side opposite to second plate member 16 are provided on the surface of third plate member 17.

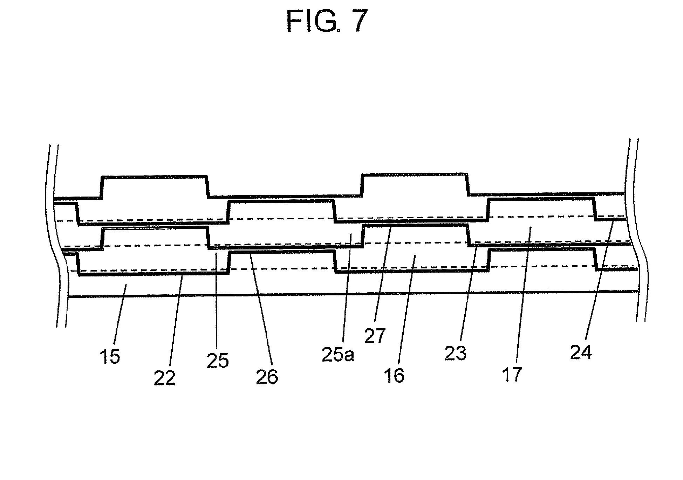

Fig. 7 is a cross-sectional view of heat exchanger 14 of the heat exchange device, taken along the line A-A of Fig. 5B. As shown in Fig. 7, first protrusions 26 are provided on a part of first rectification walls 22 of first plate member 15 so as to protrude into first recessed portions 25 formed on the lower surface side of second plate member 16 close to first plate member 15 when second rectification walls 23 are formed in second plate member 16. Moreover, second protrusions 27 are provided on a part of second rectification walls 23 of second plate member 16 so as to protrude into second recessed portions 25a which are formed on the lower surface side of third plate member 17 close to second plate member 16 when third rectification walls 24 are formed in third plate member 17.

As understood from the structures shown in Figs. 5A, 5B, and 6, plate members 15, 16, and 17 have a vertically rectangular shape, and first plate member 15 has first rectification walls 22 which extend in a straight line from one end thereof 15a (the lower end) towards the other end 15b (the upper end). Moreover, first rectification walls 22 have a curved shape that is curved in front of the other end 15b towards first long side 15c which is on the left side in Fig. 5A, whereby portions of first rectification walls 22 corresponding to first long side 15c serve as outlet port 21.

Moreover, second plate member 16 has second rectification walls 23 which extend in a straight line from the other end 16b (the upper end) towards one end thereof 16a (the lower end). Second rectification walls 23 have a curved shape that is curved in front of one end 16a towards second long side 16c which is on the right side in Fig. 5A, whereby portions of second rectification walls 23 corresponding to second long side 16c serve as outlet port 19.

Furthermore, subsequently, although third plate member 17 and fourth plate member 17a are similarly stacked alternately, description thereof will be provided briefly in order to avoid redundant description. It should be noted that third plate member 17 may be the same as that used as first plate member 15, and fourth plate member 17a stacked subsequently on third plate member 17 may be the same as that used as second plate member 16.

In addition, as shown in Fig. 5A, first curved portion 28, which is provided to first plate member 15 so as to be curved towards first long side 15c, and second curved portion 29, which is provided to second plate member 16 so as to be curved towards second long side 16c, are configured to increase the gap between first rectification walls 22 and the gap between second rectification walls 23, respectively, thus preventing any possible increase in air-flow resistance.

That is to say, when first rectification walls 22 or second rectification walls 23 are formed in first curved portion 28 or second curved portion 29 of first plate member 15 or second plate member 16 with the same density as on first long side 15c or second long side 16c, the air-flow path will be curved and the air-flow resistance will increase.

In order to prevent this, in first curved portion 28, the gap, namely the distance, between the adjacent ones of first rectification walls 22 is set to be larger than that in the straight-line portion of first rectification wall 22.

Moreover, in second curved portion 29, the gap, namely the distance, between the adj acent ones of second rectification walls 23 is set to be larger than that in the straight-line portion of second rectification walls 23.

When observing second curved portion 29 of second plate member 16, first rectification walls 22 and third rectification walls 24 which are perpendicular to second curved portion 29 are formed on portions of first plate member 15 and third plate member 17 disposed adjacent to second curved portion 29. Therefore, even when the gap between the adjacent ones of second rectification walls 23 in second curved portion 29 is increased, the adjacent wall surfaces of first plate member 15 or third plate member 17 will not protrude due to thermal expansion.

However, in Embodiment 1, a curved face which is substantially perpendicular to the straight-line portion of second rectification walls 23 is formed on a portion of first plate member 15 corresponding to first curved portion 28. Moreover, a curved face which is substantially perpendicular to the straight-line portions of first rectification walls 22 and third rectification walls 24 is formed on a portion of second plate member 16 corresponding to second curved portion 29. Although these curved faces are not shown in the drawings to avoid complication, first plate member 15 itself corresponding to first curved portion 28 and second plate member 16 itself corresponding to second curved portion 29 are curved into a gently protruding circular-arc shape, that is, a so-called barrel shape.

According to the configuration described above, the air heated by transceiver 5 in cabinet 4 is pulled into second blast fan 13 from second intake port 9 of heat exchange device 6 in the direction indicated by the arrow in Fig. 2. The heated air is drawn into heat exchanger 14 from inlet port 18 shown in Figs. 5A and 6. Then, the air passes between second plate member 16 and third plate member 17, becoming cool air which is supplied back to the inside of cabinet 4 from outlet port 19, whereby transceiver 5 is cooled down by the cool air.

On the other hand, as indicated by the broken-line arrow in Fig. 2, the outside air is pulled into first blast fan 12 from first intake port 7 and drawn into heat exchanger 14 from inlet port 20 shown in Figs. 5A and 6. Then, the air passes between first plate member 15 and second plate member 16 and is discharged to the outside of cabinet 4 from outlet port 21 via first discharge port 8.

The outside air passing between first plate member 15 and second plate member 16 and the air inside cabinet 4 passing between second plate member 16 and third plate member 17 are uniformly dispersed over approximately the entire surfaces of plate members 15, 16, and 17 by first rectification walls 22 or second rectification walls 23 which are provided on first plate member 15 or second plate member 16. With such a configuration, heat exchange between the outside air and the air inside cabinet 4 can be realized by the entire surface area of plate members 15, 16, and 17.

However, during this heat exchange, if the outside air temperature is extremely high, for example, the internal temperature of cabinet 4 will rise too high, and as a consequence, plate members 15, 16, and 17 will be thermally expanded. Thus, portions sandwiched between first rectification walls 22 or portions sandwiched between second rectification walls 23 may protrude into either one of plate members 15, 16, and 17 adjacent thereto. Therefore, there is a concern in that the air-flow path is narrowed or blocked.

Therefore, as described above, in Embodiment 1, as shown in Fig. 7, first protrusions 26 are provided on parts of first rectification walls 22 of first plate member 15 so as to protrude into first recessed portions 25, which are formed on the lower surface side of second plate member 16 close to first plate member 15 when second rectification walls 23 are formed in second plate member 16, and to make abutting contact with the inner top surfaces of first recessed portions 25 close to first plate member 15.

Moreover, second protrusions 27 are provided on parts of second rectification walls 23 of second plate member 16 so as to protrude into second recessed portions 25a, which are formed on the lower surface side of third plate member 17 close to second plate member 16 when third rectification walls 24 are formed in third plate member 17, and to make abutting contact with the inner top surfaces of second recessed portions 25a close to second plate member 16.

For this reason, even when such a high temperature state as described above occurs and thus at least any one of plate members 15, 16, and 17 is thermally expanded, first protrusions 26 of first plate member 15 supports second plate member 16 disposed on an upper side thereof by making abutting contact with first recessed portions 25 of second plate member 16 close to first plate member 15. Moreover, second protrusions 27 of second plate member 16 supports third plate member 17 disposed on an upper side thereof by making abutting contact with second recessed portions 25a of third plate member 17 close to second plate member 16. In this way, the portions sandwiched between first rectification walls 22 or the portions sandwiched between second rectification walls 23 are prevented from protruding into plate members 15, 16, and 17 adjacent thereto, thus preventing the air-flow path from being narrowed or blocked. Therefore, it is possible to realize a heat exchange device capable of operating while maintaining high heat exchange efficiency.

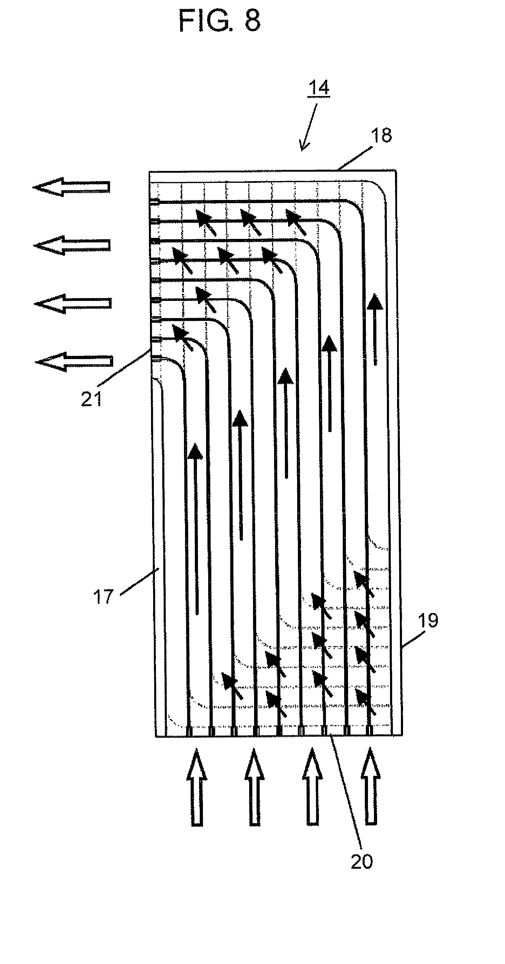

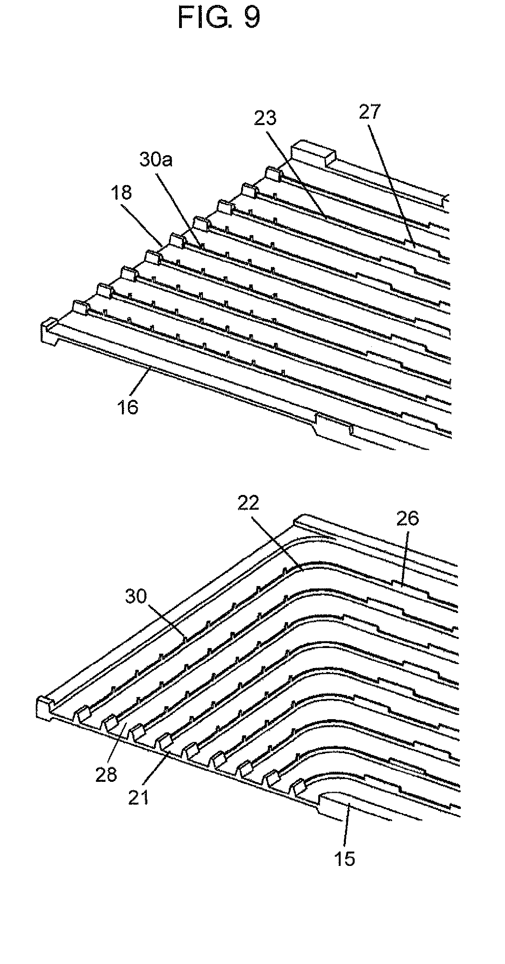

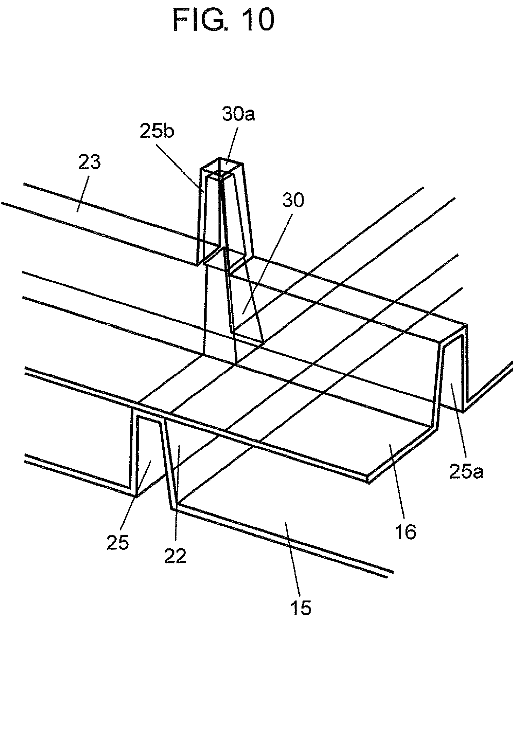

Fig. 8 is a top plan view of the heat exchanger of another heat exchange device according to Embodiment 1 of the present invention. Fig. 9 is an exploded perspective view of the heat exchanger of another heat exchange device according to Embodiment 1 of the present invention. Fig. 10 is a partial enlarged perspective view of the heat exchanger of another heat exchange device according to Embodiment 1 of the present invention.

Differently from the heat exchanger described with reference to Figs. 5 to 7, heat exchanger 14 shown in Fig. 8 prevents formation of a shortcut in the direction indicated by the arrows in the curved portion of the rectification walls.

That is to say, in the first curved portion of first rectification wall 22 of first plate member 15 shown in Fig. 10, second rectification wall 23 of second plate member 16 is perpendicular to first rectification wall 22. In this case, since first recessed portion 25 is formed on the side of first plate member 15 when second rectification wall 23 is formed, air passes through first recessed portion 25 close to first plate member 15, whereby a shortcut is formed in the first curved portion.

That is to say, a flow of air that takes a shortcut between inlet port 18 of heat exchanger 14 shown in Fig. 6 and outlet port 19 is formed, and a flow of air that takes a shortcut between inlet port 20 and outlet port 21 is formed.

Therefore, in Embodiment 1 shown in Figs. 9 and 10, first sealing protrusions 30 are provided in portions of first curved portion 28 of first rectification walls 22 of first plate member 15 being perpendicular to the straight-line portion of second rectification walls 23 of second plate member 16 adjacent to first curved portion 28 so as to protrude into first recessed portions 25 which are formed on second plate member 16 close to first plate member 15 when second rectification walls 23 are formed on second plate member 16.

Moreover, second sealing protrusions 30a are provided in portions of the straight-line portion of second rectification walls 23 of second plate member 16 being perpendicular to second curved portion 29 (not shown) of third rectification walls 24 of third plate member 17 adjacent to the straight-line portion so as to protrude into second recessed portions 25a which are formed on third plate member 17 close to second plate member 16 when third rectification walls 24 are formed on third plate member 17.

As shown in Fig. 10, first sealing protrusions 30 have such a shape that the diameter thereof decreases as it extends from first plate member 15 towards second plate member 16. Similarly, second sealing protrusions 30a have such a shape that the diameter thereof decreases as it extends from second plate member 16 towards third plate member 17. Moreover, first recessed portions 25 which are formed on the side of first plate member 15 when second rectification walls 23 are formed on second plate member 16 have such a shape that the diameter on the side of first plate member 15 is larger than that on the side of second plate member 16. Similarly, second recessed portions 25a which are formed on the side of second plate member 16 when third rectification walls 24 are formed on third plate member 17 have such a shape that the diameter on the side of second plate member 16 is larger than that on the side of third plate member 17.

For this reason, as understood from Fig. 10, first sealing protrusions 30 protruding into second recessed portions 25a are formed in portions of the curved portion of first rectification walls 22 of first plate member 15 being perpendicular to the straight-line portion of second rectification walls 23 of second plate member 16 adjacent thereto, and which are formed on second plate member 16 close to first plate member 15 when second rectification walls 23 are formed on second plate member 16, whereby a state where so-called caps are formed is achieved.

Moreover, similarly, a state is achieved where third recessed portions 25b which are formed in portions of the curved portion of third rectification walls 24 of third plate member 17 close to second plate member 16 become caps at second sealing protrusions 30a.

For this reason, it is possible to prevent formation of a shortcut in the flow of air appearing in the direction indicated by the arrows in Fig. 8 in the curved portions of first rectification walls 22, second rectification walls 23, and third rectification walls 24. As a result, it is possible to prevent decrease in heat exchange efficiency of heat exchanger 14.

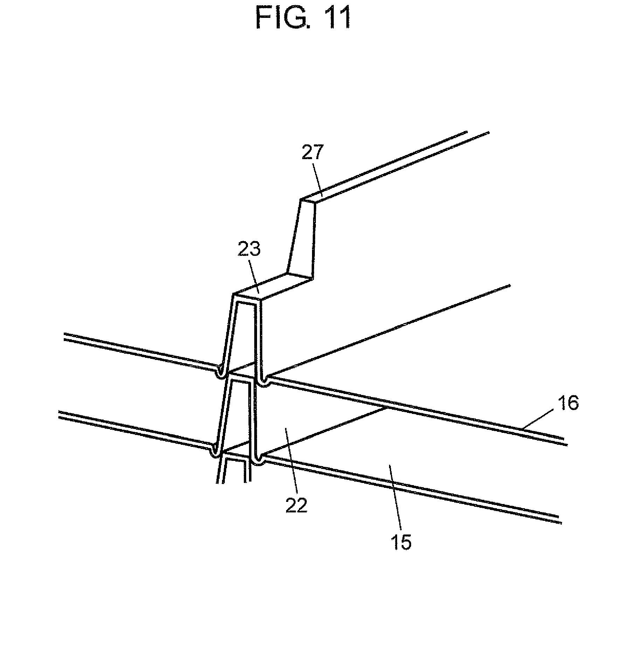

Fig. 11 is a partial enlarged perspective view of the heat exchanger of a still another heat exchange device according to Embodiment 1 of the present invention.

The still another embodiment shown in Fig. 11 prevents formation of a shortcut in the straight-line portion of first rectification walls 22 of first plate member 15 and second rectification walls 23 of second plate member 16, for example.

To achieve this, as shown in Fig. 11, both sides of second rectification walls 23 of second plate member 16 coming in close contact with first rectification walls 22 of first plate member 15 have such a shape that both the sides are depressed towards first plate member 15. Similarly, both sides of third rectification walls 24 of third plate member 17 coming in close contact with second rectification walls 23 of second plate member 16 have such a shape that both the sides are depressed towards second plate member 16. With such a configuration, it is possible to eliminate the gaps between first rectification walls 22 and second plate member 16 and the gaps between second rectification walls 23 and third plate member 17, thus preventing formation of a shortcut in the flow of air.

In Embodiment 1, in portions where the straight-line portion of first rectification walls 22 of first plate member 15 overlaps vertically with first recessed portions 25 of second plate member 16 close to the first plate member, gaps are formed between first rectification walls 22 and first recessed portions 25 on the side the first plate member, and thus, a shortcut in the flow of air can occur easily. However, by increasing the size of first protrusions 26 as much as possible, it is possible to block the gaps between first rectification walls 22 and first recessed portions 25 on the side of the first plate member, thus preventing formation of a shortcut in the flow of air and improving the heat exchange efficiency of heat exchanger 14.

Moreover, although not shown in the drawings, in portions where the straight-line portion of first rectification walls 22 overlaps vertically with the straight-line portion of second rectification walls 23, first rectification walls 22 enter into first recessed portions 25 on the side of first plate member 15, and second rectification walls 23 enter into second recessed portions 25a on the side of second plate member 16. In this way, it is possible to eliminate the gaps between first rectification walls 22 and second plate member 16 and the gaps between second rectification walls 23 and third plate member 17, thus preventing formation of a shortcut in the flow of air and improving the heat exchange efficiency of heat exchanger 14.

That is to say, the heat exchange device of the present invention includes a body case having a first intake port and a first discharge port for a first environment and a second intake port and a second discharge port for a second environment; a first blast fan for the first environment and a second blast fan for the second environment which are provided in the body case; and a heat exchanger that performs heat exchange between air of the first environment and air of the second environment in the body case. The heat exchanger has a structure in which a second synthetic resin-made plate member is stacked on the surface of a first synthetic resin-made plate member with a predetermined gap therebetween, and a third synthetic resin-made plate member is stacked on the surface of the second plate member with a predetermined gap therebetween. A plurality of first rectification walls that partitions the surface of the first plate member into a lane shape is formed on the surface, confronting the second plate member, of the first plate member, a plurality of second rectification walls that partitions the surface of the second plate member into a lane shape is formed on the surface, confronting the second plate member, of the second plate member, and a plurality of third rectification walls that partitions the surface of the third plate member into a lane shape is formed on the surface, opposite to the second plate member, of the third plate member. First protrusions are provided on parts of the first rectification walls of the first plate member so as to protrude into first recessed portions which are formed on the second rectification walls, confronting the first plate member, of the second plate member, and second protrusions are provided on parts of the second rectification walls of the second plate member so as to protrude into second recessed portions which are formed on the third rectification walls, confronting the second plate member, of the third plate member.

With such a configuration, it is possible to decrease air-flow resistance and to thus achieve smooth rectification of the flow of air. Therefore, it is possible to realize a heat exchange device capable of operating stably with high heat exchange efficiency and high mass-productivity.

That is to say, in the heat exchange device of the present invention, the plurality of first rectification walls partitioning the surface of the first plate member into a lane shape and the plurality of second rectification walls partitioning the surface of the second plate member into a lane shape are provided, respectively. In this way, it is possible to form a uniform flow of air over approximately the entire surface of the first plate member and the second plate member by the first rectification walls and the second rectification walls and to thus perform smooth rectification of the flow of air.

Furthermore, in the portion where the uniform flow of air is formed, the first protrusions are provided in parts of the first rectification walls of the first plate member so as to protrude into the first recessed portions on the first plate member, and the second protrusions are provided in parts of the second rectification walls of the second plate member so as to protrude into the second recessed portions on the second plate member. In this way, even when a temperature rise such as increased air temperature occurs, the first plate member, the second plate member, and the third plate member are prevented from being greatly deformed in the direction towards their adjacent plate member, whereby the air-flow path on the surfaces of the plate members is prevented from being narrowed or blocked. As a result, it is possible to achieve smooth rectification of the flow of air, decrease the air-flow resistance, and improve the heat exchange efficiency. Therefore, it is possible to realize a heat exchange device capable of operating stably with high heat exchange efficiency.

Even if the external state is changed and thus a situation such as increased air temperature occurs, according to the heat exchange device of the present invention, the first plate member, the second plate member, and the third plate member are prevented from being greatly deformed in the direction towards their adjacent plate member, whereby the air-flow path on the surfaces of the plate members is prevented from being narrowed or blocked. As a result, it is possible to improve the heat exchange efficiency.

Moreover, in the protrusions provided in parts of the rectification walls, the first protrusions protrude into the first recessed portions on the second plate member, and the second protrusions protrude into the second recessed portions on the side of the third plate member, whereby the stacking position of the first plate member relative to the second plate member and the stacking position of the second plate member relative to the third plate member are determined. In addition, since the protrusions secure the gap between the respective plate members, it is possible to obtain an advantage that the air-flow path in the heat exchanger is prevented from being narrowed or blocked.

Moreover, by using the heat exchange device described in Embodiment 1, it is possible to form a device for accommodating a heat generation body which includes the heat exchange device and a cabinet for accommodating the heat generation body as shown in Fig. 1, and in which the heat exchange device is mounted on an opening of the cabinet.

With such a configuration, it is possible to realize a device for accommodating a heat generation body, accommodating a heat exchange device which is capable of operating stably with high heat exchange efficiency. Since the heat exchange efficiency is high, it is possible to achieve further miniaturization than that of the conventional one. Thus, it is possible to obtain an advantage that the selection range of places where it is to be installed in a building or the like can be broadened.

### Embodiment 2

Similar to Embodiment 1, Figs. 1 to 3 show a heat exchange device according to Embodiment 2 of the present invention. That is, Fig. 1 is a perspective view showing an installation example of the heat exchange device, Fig. 2 is a cross-sectional view of the heat exchange device, and Fig. 3 is an exploded perspective view of the heat exchange device.

Description of Figs. 1 to 3 is the same as that described in Embodiment 1 and will be omitted herein.

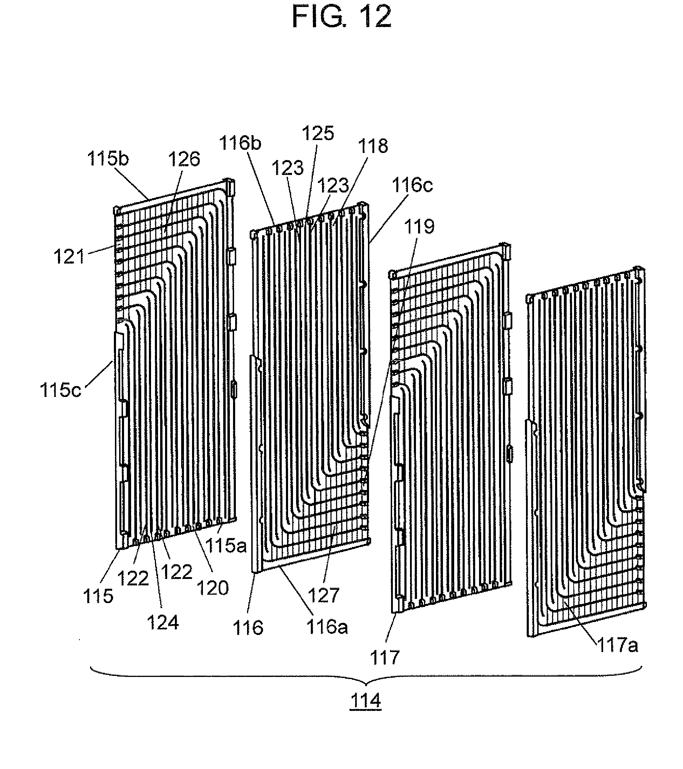

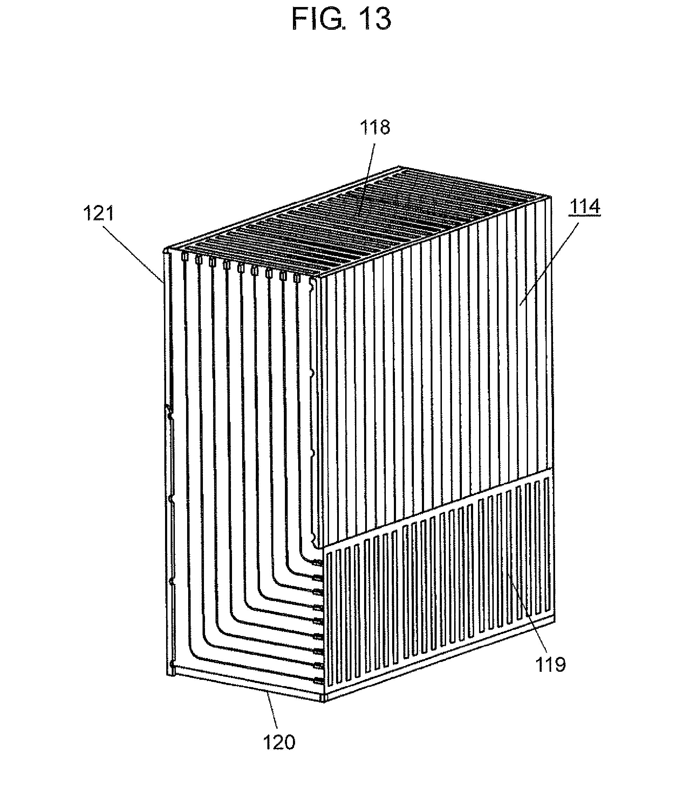

Fig. 12 is an exploded perspective view of the heat exchanger of a heat exchange device according to Embodiment 2 of the present invention. Fig. 13 is a perspective view of the heat exchanger of the heat exchange device according to Embodiment 2 of the present invention.

As shown in Figs. 12 and 13, heat exchanger 114 has a structure, for example, in which second synthetic resin-made plate member 116 is stacked on the surface of first synthetic resin-made plate member 115 with a predetermined gap therebetween, and third synthetic resin-made plate member 117 is stacked on the surface of second plate member 116 with a predetermined gap therebetween, as shown in Fig. 13. Here, plate members 115, 116, and 117 are made from synthetic resin due to its good moldability and high mass-productivity, and other similar materials having the same properties may be used. Moreover, plate members 115, 116, and 117 have a rectangular shape. In Fig. 12, although three plate members 115, 116, and 117 are stacked, a plurality of plate members may be stacked, for example, by stacking additional fourth plate member 117a and the like above third plate member 117.

The top surface (in Fig. 13) of heat exchanger 114 thus stacked serves as inlet 118 in which the air inside cabinet 4 shown in Figs, 1 and 13 is drawn via second intake port 9. The air drawn from inlet port 118 into heat exchanger 114 is subsequently discharged into cabinet 4 via outlet port 119 which is provided on the right side of the lower part in Fig. 13.

The outside air from the outside of cabinet 4 is drawn from inlet port 120, which is provided on the lower surface in Fig. 13, and is discharged to the outside of cabinet 4 via outlet port 121 which is provided on the left side of the upper part.

Although such a ventilation of the outside air will be described in further detail later, heat exchanger 114 performs cooling of transceiver 5 shown in Fig. 1. That is to say, since electric current of several tens of amperes or more flows through transceiver 5, there is a case where transceiver 5itself generates heat and the temperature thereof rises. When such a temperature rise in transceiver 5 is left as it is, the characteristics thereof may become unstable. Therefore, as described above, similar to Embodiment 1, Embodiment 2 has a structure in which heat exchanger 114 performs heat exchange between the outside air and the air flowing inside cabinet 4 to cool down the inside air, thus cooling down and suppressing heat generation of transceiver 5, and preventing the operation of transceiver 5 from becoming unstable.

Heat exchanger 114 described above is obtained by stacking second rectangular synthetic resin-made plate member 116 on the surface of first rectangular synthetic resin-made plate member 115 and third synthetic resin-made plate member 117 on the surface of second plate member 116 as shown in Fig. 12.

More specifically, a plurality of first rectification walls 122 that partitions the surface of first plate member 115 into a lane shape is provided on the surface of first plate member 115 close to second plate member 116. Moreover, a plurality of second rectification walls 123 that partitions the surface of second plate member 116 into a lane shape is provided on the surface of second plate member 116 close to third plate member 117. Furthermore, third plate member 117 is provided with rectification walls for a plate member on the right side in Fig. 12.

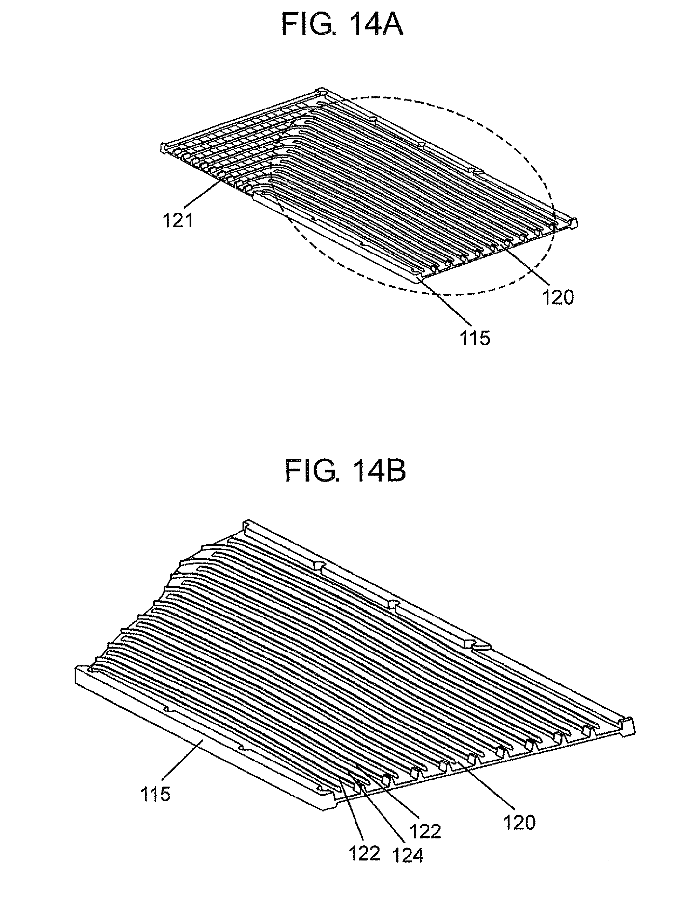

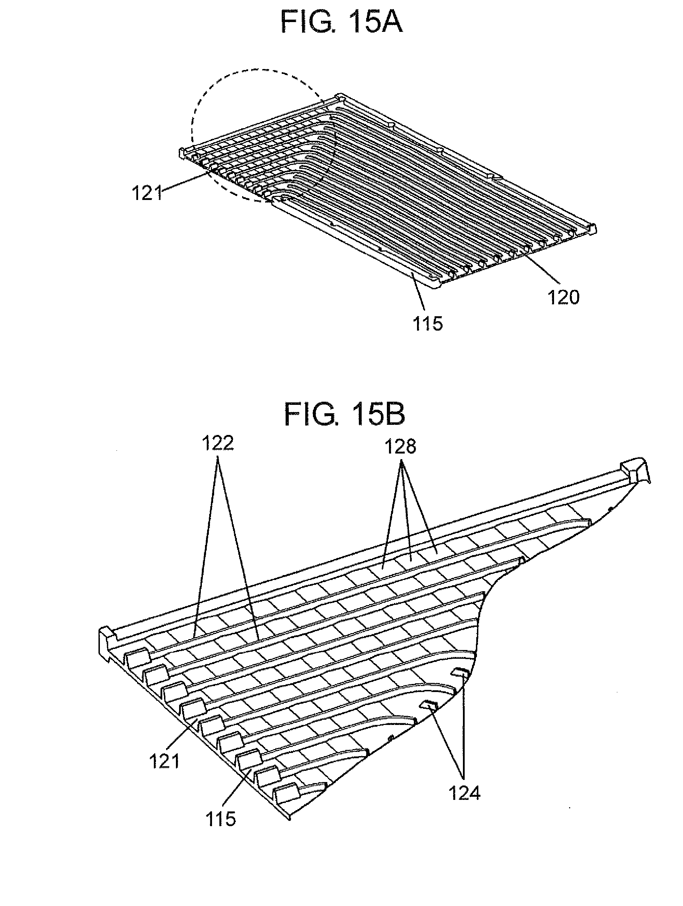

Fig. 14A is a perspective view of a main part of the heat exchanger of the heat exchange device according to Embodiment 2 of the present invention. Fig. 14B is an enlarged perspective view of the part surrounded by the broken line in Fig. 14A. Fig. 15A is a perspective view of a main part of the heat exchanger of the heat exchange device according to Embodiment 2 of the present invention. Fig. 15B is an enlarged perspective view of the part surrounded by the broken line in Fig. 15A.

As shown in Figs. 12, 14A, and 14B, first protrusions 124 are provided between first plural rectification walls 122 on the surface of first plate member 115 close to second plate member 116 so as to protrude towards second plate member 116. Moreover, second protrusions 125 are provided between second plural rectification walls 123 on the surface of second plate member 116 close to third plate member 117 so as to protrude towards third plate member 117.

Plate members 115, 116, and 117 have a vertically rectangular shape, and first plate member 115 has first rectification walls 122 which extend from a first end thereof 115a (the lower end) towards a second end 115b (the upper end) . Moreover, first rectification walls 122 have a curved shape that is curved in front of the upper end towards first long side 115c which is on the left side in Fig. 12, whereby portions of first rectification walls 122 corresponding to first long side 115c serve as outlet port 121.

Moreover, second plate member 116 has second rectification walls 123 which extend from a second end 116b (the upper end) towards a first end thereof 116a (the lower end). Second rectification walls 123 have a curved shape that is curved in front of the lower end towards second long side 116c which is on the right side in Fig. 12, whereby portions of second rectification walls 123 corresponding to second long side 116c serve as outlet port 119.

Furthermore, subsequently, although third plate member 117 and fourth plate member 117a are similarly stacked alternately, description thereof will be provided briefly in order to avoid redundant description. It should be noted that third plate member 117 may be the same as that used as first plate member 115, and fourth plate member 117a stacked subsequently on third plate member 117 may be the same as that used as second plate member 116.

In addition, as shown in Figs. 15A and 15B, first curved portion 126, which is provided to first plate member 115 so as to be curved towards first long side 115c, and second curved portion 127, which is provided to second plate member 116 so as to be curved towards the second long side, are configured as portions where first protrusions 124 or second protrusions 125 are not formed. Moreover, as shown in Fig. 15, curved surface 128 which is substantially perpendicular to first rectification walls 122 or second rectification walls 123 is formed on the portions where first protrusions 124 or second protrusions 125 are not formed.

According to the configuration described above, the air heated by transceiver 5 in cabinet 4 (Fig. 1) is pulled into second blast fan 13 from second intake port 9 of heat exchange device 6 in the direction indicated by the arrow in Fig. 2. The heated air is drawn into heat exchanger 114 from inlet port 118 shown in Figs. 13 to 15. Then, the air passes between second plate member 116 and third plate member 117, becoming cool air which is supplied back to the inside of cabinet 4 (Fig. 1) via outlet port 119 and second discharge port 10 (Fig. 2), whereby transceiver 5 is cooled down.

On the other hand, as shown in Fig. 2, the outside air is pulled into first blast fan 12 from first intake port 7. Then, the air is drawn into heat exchanger 114 from inlet port 120 as shown in Figs. 13 to 15, passes between first plate member 115 and second plate member 116, and is discharged to the outside of cabinet 4 (Fig. 1) via outlet port 121 and first discharge port 8 (Fig. 2).

The outside air passing between first plate member 115 and second plate member 116 and the air inside cabinet 4 passing between second plate member 116 and third plate member 117 are uniformly dispersed over approximately the entire surfaces of plate members 115, 116, and 117 by first rectification walls 122 and second rectification walls 123, respectively, which are provided on first plate member 115 and second plate member 116. Therefore, the heat exchange device of Embodiment 2 is able to perform heat exchange between the outside air and the air inside the cabinet by using a large area and to thus operate stably with high heat exchange efficiency.

However, during this heat exchange, if the outside air temperature is extremely high, for example, there is a case where the internal temperature of cabinet 4 may rise too high. In such a case, plate members 115, 116, and 117 may be thermally expanded as a result of the temperature rise, and portions sandwiched between first rectification walls 122 or portions sandwiched between second rectification walls 123 may protrude into plate members 115, 116, and 117 adjacent thereto. Therefore, there is a concern in that the air-flow path is narrowed or blocked.

However, as described above, in Embodiment 2, first protrusions 124 or second protrusions 125 are provided on the portions sandwiched between first rectification walls 122 or portions sandwiched between second rectification walls 123. Therefore, even when such a high temperature state as described above occurs, the portions sandwiched between first rectification walls 122 or the portions sandwiched between second rectification walls 123 protrude into plate members 115, 116, and 117 adjacent thereto. In this way, it is possible to prevent the air-flow path from being narrowed or blocked and to maintain high heat exchange efficiency.

As described above, as shown in Figs. 15A and 15B, curved face 128 which is substantially perpendicular to first rectification walls 122 or second rectification walls 123 is provided on the non-formation portion of first plate member 115 or second plate member 116 where first protrusions 124 or second protrusions 125 are not formed. Curved face 128 is provided so as to prevent any possible increase in air-flow resistance when air passes therethrough. That is to say, if protrusions 124 and 125 are provided on the non-formation portion where first protrusions 124 or second protrusions 125 are not formed, there will be a considerable increase in the air-flow resistance.

As understood when observing the non-formation portion of second plate member 116, first protrusions 124 are formed on portions of first plate member 115 disposed adjacent to this non-formation portion and portions of third plate member 117 opposing this non-formation portion. Therefore, even if second protrusions 125 are not provided on the non-formation portion of second plate member 116, the adjacent wall surfaces will not protrude due to thermal expansion. However, in order to prevent or alleviate the protruding of the wall surfaces further, it may be preferable to provide curved surface 128 on this non-formation portion as described above.

That is to say, the heat exchange device of the present invention includes a body case having a first intake port and a first discharge port for a first environment, and a second intake port and a second discharge port for a second environment; a first blast fan for the first environment and a second blast fan for the second environment which are provided in the body case; and a heat exchanger that performs heat exchange between air of the first environment and air of the second environment in the body case. The heat exchanger has a structure in which a second synthetic resin-made plate member is stacked on the surface of a first synthetic resin-made plate member with a predetermined gap therebetween, and a third synthetic resin-made plate member is stacked on the surface of the second plate member with a predetermined gap therebetween. A plurality of first rectification walls that partitions the surface of the first plate member into a lane shape is formed on the surface, confronting the second plate member, of the first plate member, and a plurality of second rectification walls that partitions the surface of the second plate member into a lane shape is formed on the surface, confronting the second plate member, of the second plate member. First protrusions are provided between the first plurality of rectification walls on the surface, confronting the second plate member, of the first plate member so as to protrude towards the second plate member, and second protrusions are provided between the second plurality of rectification walls on the surface, confronting the second plate member, of the second plate member so as to protrude towards the third plate member.

With such a configuration, it is possible to decrease air-flow resistance and to thus achieve smooth rectification of the flow of air. Therefore, it is possible to realize a heat exchange device capable of operating stably with high heat exchange efficiency and high mass-productivity.

That is to say, in the heat exchange device of the present invention, the plurality of first rectification walls that partitions the surface of the first plate member into a lane shape and the plurality of second rectification walls that partitions the surface of the second plate member into a lane shape are provided. Moreover, the first protrusions are provided between the first plural rectification walls so as to protrude towards the second plate member, and the second protrusions are provided between the second plural rectification walls so as to protrude towards the third plate member.

In this way, it is possible to form a uniform flow of air over approximately the entire surface of the first plate member and the second plate member by the first rectification walls and the second rectification walls. Moreover, since the first protrusions and the second protrusions are provided in the portion where the uniform flow of air is formed, even when a situation such as increased air temperature occurs, the air-flow path is prevented from being narrowed or blocked. As a result, it is possible to achieve smooth rectification of the flow of air, decrease the air-flow resistance, and improve the heat exchange efficiency. Therefore, it is possible to realize a heat exchange device capable of operating stably with high heat exchange efficiency.

Moreover, by using the heat exchange device described in Embodiment 2, it is possible to form a device for accommodating a heat generation body which includes the heat exchange device and a cabinet for accommodating the heat generation body as shown in Fig. 1, and in which the heat exchange device is mounted on an opening of the cabinet.

With such a configuration, it is possible to realize a device for accommodating a heat generation body, accommodating a heat exchange device which is capable of operating stably with high heat exchange efficiency. Since the heat exchange efficiency is high, it is possible to achieve further miniaturization than in a conventional heat exchange device. Thus, it is possible to obtain an advantage that the selection range of places where it may be installed in a building or the like can be broadened.

### INDUSTRIAL APPLICABILITY

The heat exchange device of the present invention can operate stably with high heat exchange efficiency and high mass-productivity. Therefore, the heat exchange device can be extremely useful as a cooling device used in facilities of a base station of communication devices including cellular phones and other outdoor facilities.

## Claims

1. A heat exchange device comprising:
a body case having a first intake port and a first discharge port for a first environment, and a second intake port and a second discharge port for a second environment;
a first blast fan for the first environment and a second blast fan for the second environment which are provided in the body case; and
a heat exchanger that performs heat exchange between air of the first environment and air of the second environment in the body case,
wherein the heat exchanger has a structure in which a second synthetic resin-made plate member is stacked on the surface of a first synthetic resin-made plate member with a predetermined gap therebetween, and a third synthetic resin-made plate member is stacked on the surface of the second plate member with a predetermined gap therebetween,
wherein a plurality of first rectification walls that partitions the surface of the first plate member into a lane shape is formed on the surface, confronting the second plate member of the first plate member, a plurality of second rectification walls that partitions the surface of the second plate member into a lane shape is formed on the surface, confronting the third plate member of the second plate member, and a plurality of third rectification walls that partitions the surface of the third plate member into a lane shape is formed on the surface, opposite to the second plate member, of the third plate member, and
wherein first protrusions are provided on parts of the first rectification walls of the first plate member so as to protrude into first recessed portions which are formed on the second rectification walls, confronting the first plate member, of the second plate member, and second protrusions are provided on parts of the second rectification walls of the second plate member so as to protrude into second recessed portions which are formed on the third rectification walls, confronting the second plate member, of the third plate member.

2. The heat exchange device of claim 1,
wherein the first plate member has the first rectification walls which extend in a straight line from a first end thereof towards a second end so that the first rectification walls have a curved shape that is curved in front of the other end towards a first long side of the first plate member, and
wherein the second plate member has the second rectification walls which extend in a straight line from a second end towards a first end thereof so that the second rectification walls have a curved shape that is curved in front of the first end towards a second long side of the second plate member.

3. The heat exchange device of claim 2,
wherein in a first curved portion of the first rectification walls of the first plate member, a distance between adjacent curved portions of the first rectification walls is larger than that between the straight-line portions of the first rectification walls, and
wherein in a second curved portion of the second rectification walls of the second plate member, a distance between adjacent curved portions of the second rectification walls is larger than that between the straight-line portions of the second rectification walls.

4. The heat exchange device of claim 3,
wherein a first curved face which is perpendicular to the straight-line portion of the second rectification walls of the second plate member is provided on the first curved portion of the first plate member being curved towards the first long side, and
wherein a second curved face which is perpendicular to the straight-line portion of the first rectification walls is provided on the second curved portion of the second plate member being curved towards the second long side.

5. The heat exchange device of claim 4,
wherein the first curved face, which is perpendicular to the straight-line portion of the second rectification walls of the second plate member and which is provided on the first curved portion of the first plate member being curved towards the first long side, is formed by processing the first plate member itself;
wherein the second curved face which is perpendicular to the straight-line portion of the first rectification walls and which is provided on the second curved portion of the second plate member being curved towards the second long side, is formed by processing the second plate member itself.

6. The heat exchange device of claim 5,
wherein the first curved face is formed by processing the first plate member itself into a protruding circular-arc shape, and
wherein the second curved face is formed by processing the second plate member itself into a gently protruding circular-arc shape.

7. The heat exchange device of any one of claims 1 to 6,
wherein the first protrusions protrude into the first recessed portions on the first plate member so as to make contact with inner top faces thereof, and
wherein the second protrusions protrude into the second recessed portions on the second plate member so as to make contact with the inner top faces thereof.

8. The heat exchange device of any one of claims 1 to 7,
wherein first sealing protrusions are provided in sections of the first curved portion of the first rectification walls of the first plate member, which sections are perpendicular to the straight-line portion of the second rectification walls of the second plate member, which straight-line portion is adjacent to the first curved portion, so as to protrude into the first recessed portions on the first plate member, and
wherein second sealing protrusions are provided in sections of the straight-line portion of the second rectification walls of the second plate member, which sections are perpendicular to a third curved portion of the third rectification walls of the third plate member adjacent to the straight-line portion, so as to protrude into the second recessed portions on the second plate member.

9. The heat exchange device of claim 8,
wherein the first sealing protrusions have such a shape that a diameter thereof decreases as each one of the protrusions extends from the first plate member towards the second plate member,
wherein the second sealing protrusions have such a shape that a diameter thereof decreases as each one of the protrusions extends from the second plate member towards the third plate member,
wherein the first recessed portions on the first plate member have such a shape that a diameter on the side of the first plate member is larger than that on the side of the second plate member, and
wherein the second recessed portions on the side of the second plate member have such a shape that a diameter on the side of the second plate member is larger than that on the side of the third plate member.

10. The heat exchange device of any one of claims 1 to 9,
wherein both sides of the second rectification walls of the second plate member coming in close contact with the first rectification walls of the first plate member have such a shape that both the sides are depressed towards the first plate member, and
wherein both sides of the third rectification walls of the third plate member coming in close contact with the second rectification walls of the second plate member have such a shape that both the sides are depressed towards the second plate member.

11. A heat exchange device comprising:
a body case having a first intake port and a first discharge port for a first environment, and a second intake port and a second discharge port for a second environment;
a first blast fan for the first environment and a second blast fan for the second environment which are provided in the body case; and
a heat exchanger that performs heat exchange between air of the first environment and air of the second environment in the body case,
wherein the heat exchanger has a structure in which a second synthetic resin-made plate member is stacked on the surface of a first synthetic resin-made plate member with a predetermined gap therebetween, and a third synthetic resin-made plate member is stacked on the surface of the second plate member with a predetermined gap therebetween,
wherein a plurality of first rectification walls that partitions the surface of the first plate member into a lane shape is formed on the surface, confronting the second plate member, of the first plate member, and a plurality of second rectification walls that partitions the surface of the second plate member into a lane shape is formed on the surface, confronting the second plate member, and
wherein first protrusions are provided between the first plurality of rectification walls on the surface, confronting the second plate member, of the first plate member so as to protrude towards the second plate member, and second protrusions are provided between the second plurality of rectification walls on the surface, confronting the third plate member, of the second plate member so as to protrude towards the third plate member.

12. The heat exchange device of claim 11,
wherein the first plate member has the first rectification walls which extend from a first end thereof towards a second end so that the first rectification walls have a curved shape that is curved in front of the second end towards a first long side of the first plate member, and
wherein the second plate member has the second rectification walls which extend from a second end towards a first end thereof so that the second rectification walls have a curved shape that is curved in front of the first end towards a second long side of the second plate member.

13. The heat exchange device of claim 12,
wherein at least one of a first curved portion of the first plate member being curved towards the first long side and a second curved portion of the second plate member being curved towards the second long side has a non-formation portion of the first protrusions or a non-formation portion of the second protrusions.

14. The heat exchange device of claim 13,
wherein a curved face is provided to one of the first plate member at the non-formation portion of the first protrusions and the second plate member at the non-formation portion of the second protrusions such that the curved face is perpendicular to one of the first rectification walls at the non-formation portion of the first protrusions and the second rectification walls at the non-formation portion of the second protrusions.

15. A device for accommodating a heat generation body, comprising:
a cabinet for accommodating a heat generation body; and
the heat exchange device of any one of claims 1 to 14 mounted to an opening of the cabinet.
